**Europäisches Patentamt**

**European Patent Office**

**Office européen des brevets**

(11) Veröffentlichungsnummer: **0 025 962**
B1

(12) **EUROPÄISCHE PATENTSCHRIFT**

(45) Veröffentlichungstag der Patentschrift:
19.10.83

(21) Anmeldenummer: **80105511.2**

(22) Anmeldetag: **13.09.80**

(51) Int. Cl.³: **G 03 D 15/06**, G 03 F 7/16

(54) **Dosiervorrichtung für Lack.**

(30) Priorität: **24.09.79 DE 2938521**

(43) Veröffentlichungstag der Anmeldung:
**01.04.81 Patentblatt 81/13**

(45) Bekanntmachung des Hinweises auf die Patenterteilung:
**19.10.83 Patentblatt 83/42**

(84) Benannte Vertragsstaaten:
**BE DE FR GB IT NL SE**

(56) Entgegenhaltungen:
**DE-A-1 244 582**
**DE-A-2 751 371**
**DE-A-2 756 932**
**US-A-3 970 040**
**US-A-4 085 672**
**US-A-4 102 266**

(73) Patentinhaber: **HOECHST AKTIENGESELLSCHAFT,**
**Postfach 80 03 20, D-6230 Frankfurt am Main 80 (DE)**

(72) Erfinder: **Töpfer, Dieter, Mühlweg 5,**
**D-6209 Heidenrod 3 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

Dosiervorrichtung für Lack

Die Erfindung betrifft eine Dosiervorrichtung für Lack in einem Entwicklungsgerät für Druckplatten, mit mindestens einer aus elastischem Material bestehenden Rakel, die in einer Führungsleiste lösbar befestigt ist, die mit einer Rakelhalterung in Verbindung steht, deren Enden in je ein nach oben offenes U-Profilstück mit je zwei durch einen Steg beabstandeten Schenkeln von oben einführbar sind, mit an der Oberseite der Rakelhalterung beidseitig vorhandenen Einstellmitteln.

Eine derartige Rakeleinrichtung ist aus der DE-OS 2 756 932 bekannt und ist mit Haltemitteln versehen, mit denen die Abstreifrakel an zwei Seitenschilden der Druckplattenentwicklungsmaschine anbringbar ist. Jedes der U-Profilstücke ist mit seinem Steg an je einem Seitenschild derartig befestigt, daß seine beiden Schenkel quer zur Druckplattentransportrichtung zum Inneren der Druckplattenentwicklungsmaschine gerichtet sind. An der Oberseite einer Trägerleiste, die mit der Führungsleiste in Verbindung steht, sind beidseitig Stützmittel angebracht, mit denen sich die Trägerleiste sowie die mit ihr verbundene Führungsleiste und die Abstreifrakel auf je einem U-Profilstück abstützt. Diese Rakeleinrichtung ermöglicht es, sowohl die Führungsleiste mit der Rakel als auch die Rakel allein schnell und ohne Werkzeug aus der Druckplattenentwicklungsmaschine auszubauen und zu reinigen bzw. im Bedarfsfall auszutauschen.

Im Stand der Technik ist auch eine Rakeleinrichtung mit einer Abstreifrakel bekannt, die aus einem schmalen zugeschnittenen Gummistreifen besteht, der in ein gekantetes U-Profil eingelegt wird, dessen Schenkel danach zusammengedrückt werden. Dieses U-Profil dient als Führungsleiste für die Rakel. Zusätzlich wird die Rakel an voneinander beabstandeten Stellen mit dem U-Profil verschraubt. Diese Führungsleiste mit der eingelegten Abstreifrakel ist wenig formstabil und wird daher mit einem Rakelträger, der mit Befestigungselementen in der Maschine verbunden ist, zu einer Trägerleiste verschraubt.

Bei dieser bekannten Rakeleinrichtung ist nachteilig, daß die Abstreifrakel nur verhältnismäßig umständlich und mit Hilfe von Werkzeug ausgewechselt werden kann. Dies geschieht in der Weise, daß zunächst die Trägerleiste ausgebaut wird, anschließend das U-Profil mit dem Gummistreifen vollständig abgeschraubt wird und danach die Befestigungsschrauben des Gummistreifens von der Führungsleiste gelöst werden und zuletzt der Gummistreifen ausgetauscht werden kann. Diese Arbeiten und die anschließende Montage können oft nicht durch den Benutzer der Maschine, sondern nur durch geschultes Kundendienstpersonal vorgenommen werden. Besonders schwierig gestaltet sich der Austausch des die Abstreifrakel bildenden schmalen Gummistreifens, da sich dieser beim Einklemmen in die Führungsleiste infolge der Weichheit des Rakelgummis insbesondere an den Stellen der Schraubenbefestigung verformt, so daß die Abstreifkante der Abstreifrakel nicht mehr ohne weiteres gerade verläuft. Deswegen muß häufig die Abstreifkante der Rakel nach dem Einklemmen des Gummistreifens in die Führungsleiste nachgeschnitten werden.

Aus der US-PS 3 983 758 ist eine Einrichtung zur Befestigung eines Schwammes in einer automatischen Entwicklungsmaschine für Offset-Druckplatten bekannt. Diese Einrichtung unterscheidet sich gattungsmäßig von der vorliegenden Rakeleinrichtung, obwohl mit beiden Vorrichtungen eine Flüssigkeit auf einer Druckplatte verteilt wird. Der Schwamm übt eine andere Funktion als die Abstreifrakel aus. Zum Verteilen der Flüssigkeit ist der Schwamm quer zur Transportrichtung der Druckplatte auf dieser hin- und herbewegbar. Auf der Eingabeseite der Druckplatte in die Entwicklungsmaschine verreibt der hin- und herbewegbare Schwamm die Entwicklerlösung. Auf der Ausgangsseite wird durch den Schwamm Waschwasser auf der Druckplatte verrieben. Der Schwamm ist in einen U-förmig nach unten geöffneten Kanal eingelassen, den ein Stab trägt, der aus einem Seitenschild der Entwicklungsmaschine herausragt, wobei das herausragende Ende mit einem Kurbelantrieb gekuppelt ist. An der Austrittsstelle des Schwammstabs ist der Seitenschild mit je zwei Gleitsteine verstärkt, die eine Öffnung umgeben, in die der Schwammstab von oben eingelegt werden kann. Die Gleitsteine führen den Schwammstab in Richtung der Hin- und Herbewegung quer zur Druckplattentransportrichtung.

Diese Konstruktion der Schwammeinrichtung läßt sich nicht ohne weiteres auf eine Rakeleinrichtung übertragen, da die Abstreifrakel in der Entwicklungsmaschine feststehend angeordnet werden muß und da der Anpreßdruck der Rakel auf die Druckplatte anders zu bemessen ist als der Reibedruck des Schwammes.

Bei Rakeleinrichtungen ist es bekannt, je nach dem Verwendungszweck der einzelnen Rakel, diese entweder unter Druck an die Oberfläche der Druckplatte anliegen zu lassen oder im Falle eines Dosierens einer Flüssigkeit einen schmalen Spalt zwischen der Unterkante der Rakel und der Oberfläche der Druckplatte einzustellen, wobei dieser Spalt die Höhe der auf der Rakel aufzubringenden Flüssigkeitsschicht bestimmt.

Für die Entwicklung und Lackierung von Druckplatten für die Negativ-Kopie werden zwei Maschinen benutzt, nämlich eine Entwicklungsmaschine zum Aufbringen der Entwicklerflüssigkeit und eine Lackiermaschine, die die entwickelte Druckplatte mit einer Lackschicht überzieht. Diese Verarbeitungsweise mit zwei Maschinen ist zeitaufwendig und daher in der Praxis, insbesondere in Zeitungsbetrieben, aus Zeitgründen nicht vertretbar.

Aufgabe der Erfindung ist es, eine Vorrichtung zu schaffen, die das Entwickeln und Lackieren von Druckplatten mit einstellbarer Dosierung des Lacks in zeitsparender Weise in einem Arbeitsgang ermöglicht.

Diese Aufgabe wird erfindungsgemäß durch eine Dosiervorrichtung mit den Merkmalen des Oberbegriffs des Anspruchs 1 dadurch gelöst, daß eine zweite Rakel parallel zu der ersten Rakel vorhanden ist, daß die beiden Rakeln ein Lackbad begrenzen, das zwischen ihnen aufgestaut ist, und daß die zweite Rakel mit einer Justiervorrichtung verbunden ist und durch diese in ihrer Höhe unabhängig von der Höhe der ersten Rakel einstellbar ist.

In Ausbildung der Erfindung ist oberhalb des Lackbades ein Sprührohr für die Zufuhr des Lacks zu dem Lackbad angeordnet und steht das Sprührohr über einen Schlauchanschluß mit einer Dosierpumpe in Verbindung, die in ihrer Laufzeit über ein Zeitglied steuerbar ist.

In Ausbildung der Erfindung haben die beiden Rakeln in horizontaler Richtung gleichbleibenden Abstand voneinander, sind beide Rakeln unter einem von 90° abweichenden Winkel zu der Druckplatte geneigt und bildet die in Durchlaufrichtung der Druckplatte gesehen zweite Rakel einen Spalt zwischen der Rakelunterseite und der Druckplattenoberfläche, während die erste Rakel dichtend auf der Druckplattenoberfläche aufliegt.

Die weitere Ausbildung der Erfindung ergibt sich aus den kennzeichnenden Merkmalen der Ansprüche 4 bis 7.

Die Erfindung wird im folgenden anhand eines zeichnerisch dargestellten Ausführungsbeispiels näher erläutert. Es zeigt

Fig. 1 eine schematische Schnittansicht durch die Dosiervorrichtung in Richtung auf ein Seitenschild einer Druckplattenentwicklungsmaschine und

Fig. 2 eine Vorderansicht eines Abschnitts der Dosiervorrichtung im Bereich eines Seitenschildes.

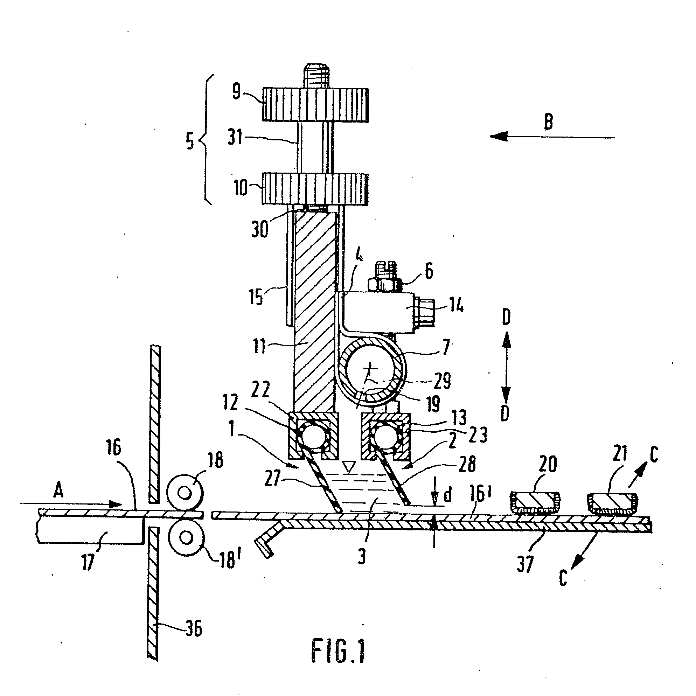

Die in Fig. 1 schematisch im Schnitt dargestellte Dosiervorrichtung umfaßt u. a. eine erste Rakel 1 und eine zweite Rakel 2. Die erste Rakel 1 wirkt als Staurakel, während die zweite Rakel 2 eine Dosierrakel ist. Beide Rakeln bestehen aus elastischem Material, beispielsweise Gummi und weisen Kopfleisten 12 bzw. 13 auf, die annähernd ringförmig ausgebildet sind und nach unten in schrägverlaufende blattförmige Lippen 27 bzw. 28 übergehen.

Die Rakel 1 ist mit ihrer Kopfleiste in eine Führungsleiste 22 eingeschoben, die aus einem kastenförmigen U-Profilstück besteht, das nach unten hin geöffnet ist. Die Führungsleiste 22 ist mit einer Rakelhalterung 11 verbunden, auf deren Oberseite ein Gewindebolzen 30 eingelassen ist. Mit dem Gewindebolzen 30 befinden sich zwei Einstellmuttern 9 und 10 im Eingriff, die durch ein Abstandstück 31 auf Distanz gehalten sind. Die beiden einstückigen Muttern 9 und 10 sind als Rändelmuttern ausgebildet, wobei mit Hilfe der unteren Einstellmutter 10 die Höheneinstellung der Rakelhalterung 11 einjustiert wird und mit der oberen Einstellmutter 9 die Konterung der Rakelhalterung 11 erfolgt.

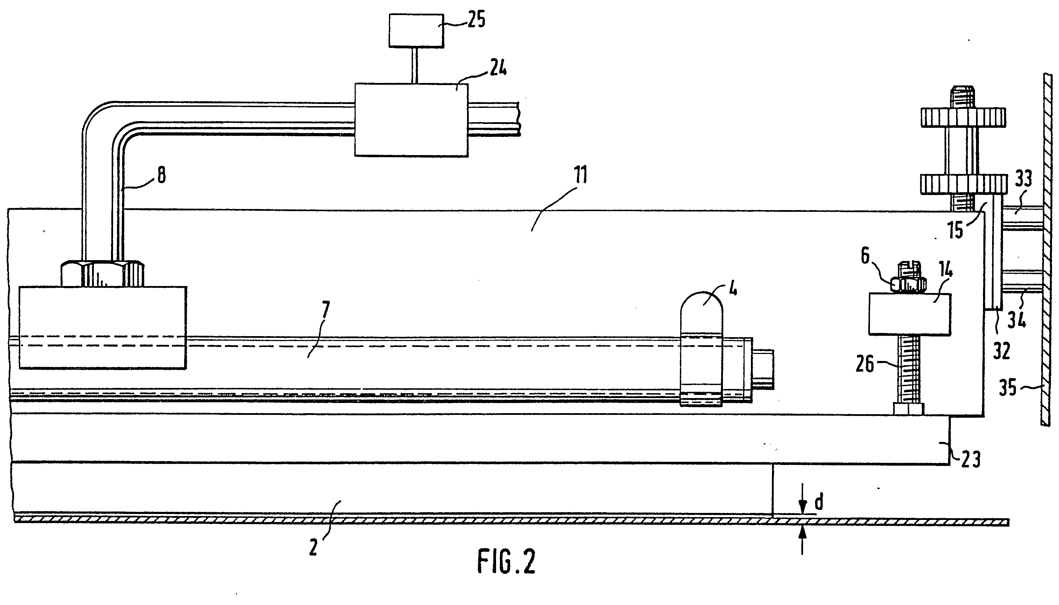

Wie aus den Fig. 1 und 2 gemeinsam ersichtlich ist, wobei die Fig. 2 eine Ansicht in Richtung B der Fig. 1 wiedergibt, besitzt die Führung 15 ein U-förmiges Profil, dessen zwei parallele Schenkel die Rakelhalterung 11 seitlich im oberen Teil umschließen. Die beiden Schenkel verbindet ein Steg 32, wie in Fig. 2 erkennbar ist, der über Bolzen 33 und 34 an einem Seitenschild 35 der Entwicklungsmaschine angebracht ist.

In Fig. 2 ist nur die rechte Hälfte der Dosiervorrichtung dargestellt. Die linke Hälfte ist in gleicher Weise ausgebildet und aus Gründen der besseren Übersichtlichkeit nicht gezeigt. Die Höhenlage der Rakel 1 wird derart eingestellt, daß die Lippe 27 auf einer Druckplatte 16' bzw. auf dem Boden der Entwicklungsmaschine zur Anlage gelangt. Der Anpreßdruck der Lippe 27 wird durch die Höheneinstellung der Rakelhalterung 11 mittels der unteren Einstellmutter 10 festgelegt. Wenn die richtige Höheneinstellung gefunden ist, wird die obere Einstellmutter 9 in Richtung auf die untere Einstellmutter 10 aufgeschraubt, um die gefundene Höhenlage zu fixieren. Eine Druckplatte 16 wird über einen Auflagetisch 17 durch einen Spalt in einem Seitenschild 36 den Entwicklungsmaschineneinzugswalzen 18, 18' zugeführt, die die Vorderkante der Druckplatte 16 erfassen und diese in Richtung A unterhalb der Dosiervorrichtung weitertransportieren. In Richtung A gesehen sind nach der Dosiervorrichtung Plüschbalken 20 und 21 angeordnet, die oszillierende Bewegungen quer zu der Durchlaufrichtung der Druckplatte 16' ausführen, wie dies durch den Doppelpfeil C-C angedeutet ist. Bei den beiden Plüschbalken handelt es sich um den Lackierungsplüsch 20 und um den Ausreibeplüsch 21.

Die beiden Rakel 1 und 2 sind zueinander parallel angeordnet und begrenzen ein Lackbad 3, das zwischen diesen beiden Rakeln aufgestaut ist. Das Lackbad 3 zwischen den beiden Rakeln 1 und 2 wird mittels einer Dosierpumpe 24 aufgebaut, deren Laufzeit über ein Zeitglied 25 (vgl. Fig. 2) gesteuert wird. Dazu führt von der Dosierpumpe 24 ein Schlauchanschluß 8 zu einem Sprührohr 7, das eine Anzahl von Auslässen 19 aufweist, die über die Länge des Sprührohrs gleichmäßig verteilt sind. Durch die über das Zeitglied 25 gesteuerte Dosierpumpe 24 wird insgesamt nur die für die Entwicklung der Platte benötigte Lackmenge zugegeben. Da im Gegensatz zu den bekannten Maschinen der Lack nicht im Umwälzsystem angetragen wird, ergibt sich ein sehr sparsamer Lackverbrauch.

Die Mittellinien 29 der Auslässe 19 des Sprührohrs 7 bilden mit der Vertikalen einen spitzen Winkel und sind so ausgerichtet, daß sie auf die Oberfläche des von den beiden Rakeln 1 und 2 eingeschlossenen Lackbades 3 weisen. Dadurch wird vermieden, daß Lack in größerem Umfang außen auf die Führungsleiste 22 aufgesprüht wird. Die Rakel 2 ist mit einer Justiervorrichtung 6 verbunden und kann durch diese in ihrer Höhe unabhängig von der Höhe der Rakel 1 eingestellt werden. In den Fig. 1 und 2 ist gezeigt, daß die Rakel 2 einen Spalt d zwischen der Rakelunterseite und der Druckplattenoberfläche bildet, während die Rakel 1 dicht auf der Druckplattenoberfläche aufliegt. Die beiden Rakeln 1 und 2 haben in Horizontalrichtung gleichbleibenden Abstand voneinander und sind unter einem von 90° abweichenden Winkel zu der Druckplattenoberfläche geneigt. Mit Hilfe der Justiervorrichtung 6 kann innerhalb eines Bereiches jeder gewünschte Spalt zwischen der Rakelunterkante und der Druckplattenoberfläche eingestellt werden. Durch diesen Spalt d wird von der durch die Entwicklungsmaschine transportierten Druckplatte auf deren Oberfläche Lack mitgenommen. Die gewünschte Lackmenge kann durch den Spalt d entsprechend dosiert werden. Nach dem Auftragen des Lacks gelangt die Druckplatte mit dem entsprechenden Lackfilm auf der Oberfläche mit den oszillierenden Plüschbalken 20 und 21 in Kontakt und wird entwickelt und gleichzeitig lackiert.

Die Führungsleiste 23 der Rakel 2 ist nahe an ihren seitlichen Enden mit je einem Gewindebolzen 26 verbunden, der an der Oberseite der Führungsleiste 23 angebracht ist. Jeder Gewindebilzen ist durch eine Halterung 14 hindurchgeführt und steht mit einer Justiervorrichtung 6, beispielsweise einer Justierschraube, im Eingriff, die auf der Halterung 14 aufsitzt. Durch Drehen der Justierschraube 6 führt der Gewindebolzen 26 eine Auf- oder Abbewegung aus, wie dies in Fig. 1 durch den Pfeil D-D angezeigt ist. Dadurch kann der Spalt d zwischen der Rakelunterkante der Lippe 28 und der Druckplattenoberfläche variiert werden. Jede Halterung 14 ist mit der Rakelhalterung 11 verbunden und mit dieser zusammen ortsfest angeordnet. Das aus den Einstellmuttern 9 und 10 sowie dem Abstandsstück 31 gebildete Justiersystem 5 ermöglicht es, beide Rakeln 1 und 2 gemeinsam zu verstellen, da die Halterung 14 mit der Rakelhalterung 11 in Verbindung steht. Unabhängig davon kann dann die Rakel 2 noch zusätzlich durch die Justiervorrichtung 6 höhenverstellt werden.

Das Sprührohr 7 wird an seinen Enden von Rohrmanschetten 4 gehalten, deren Enden zusammengeführt sind und die in nicht dargestellter Weise an der Rakelhalterung 11 befestigt sind.

## Patentansprüche

1. Dosiervorrichtung für Lack in einem Entwicklungsgerät für Druckplatten, mit mindestens einer aus elastischem Material bestehenden Rakel, die in einer Führungsleiste lösbar befestigt ist, die mit einer Rakelhalterung in Verbindung steht, deren Enden in je ein nach oben offenes U-Profilstück mit je zwei durch einen Steg beabstandeten Schenkeln von oben einführbar sind, mit an der Oberseite der Rakelhalterung beidseitig vorhandenen Einstellmitteln, dadurch gekennzeichnet, daß eine zweite Rakel (2) parallel zu der ersten Rakel (1) vorhanden ist, daß die beiden Rakeln ein Lackbad (3) begrenzen, das zwischen ihnen aufgestaut ist und daß die zweite Rakel (2) mit einer Justiervorrichtung (6) verbunden ist und durch diese in ihrer Höhe unabhängig von der Höhe der ersten Rakel (1) einstellbar ist.

2. Dosiervorrichtung nach Anspruch 1, dadurch gekennzeichnet, daß oberhalb des Lackbades (3) ein Sprührohr (7) für die Zufuhr des Lacks zu dem Lackbad (3) angeordnet ist und daß das Sprührohr (7) über einen Schlauchanschluß (8) mit einer Dosierpumpe (24) in Verbindung steht, deren Laufzeit über ein Zeitglied (25) steuerbar ist.

3. Dosiervorrichtung nach den Ansprüchen 1 oder 2, dadurch gekennzeichnet, daß die beiden Rakeln (1, 2) in Horizontalrichtung gleichbleibenden Abstand voneinander haben, daß beide Rakeln unter einem von 90° abweichenden Winkel zu der Druckplatte (16, 16') geneigt sind und daß die in Durchlaufrichtung A der Druckplatte (16') gesehen zweite Rakel (2) einen Spalt (d) zwischen der Rakelunterseite und der Druckplattenoberfläche bildet, während die erste Rakel (1) dichtend auf der Druckplattenoberfläche aufliegt.

4. Dosiervorrichtung nach einem der Ansprüche 1 bis 3, dadurch gekennzeichnet, daß die Rakeln (1, 2) gleichartig ausgebildet sind und eine im Querschnitt annähernd ringförmige Kopfleiste (12, 13) aufweisen, die nach unten in eine schräg verlaufende blattförmige Lippe (27, 28) übergeht.

5. Dosiervorrichtung nach einem der Ansprüche 1 bis 4, dadurch gekennzeichnet, daß nahe den seitlichen Enden der Führungsleiste (23) der zweiten Rakel (2) je ein Gewindebolzen (26) an der Oberseite der Führungsleiste (23) angebracht ist, der durch eine Halterung (14) hindurchgeführt ist und mit einer Justiervorrichtung (6), die auf der Halterung (14) aufsitzt, im Eingriff steht.

6. Dosiervorrichtung nach Anspruch 5, dadurch gekennzeichnet, daß die Halterung (14) mit der Rakelhalterung (11) in Verbindung steht und zusammen mit dieser ortsfest angebracht ist.

7. Dosiervorrichtung nach Anspruch 2, dadurch gekennzeichnet, daß das Sprührohr (7) eine Anzahl von Auslässen (19) aufweist, die über die Länge des Sprührohrs gleichmäßig verteilt sind und daß die Mittellinien (29) der Auslässe (19) mit der Vertikalen einen spitzen Winkel einschließen und auf die Oberfläche des von den Rakeln (1, 2) eingeschlossenen Lackbades (3) gerichtet sind.

### Claims

1. A metering device for lacquer, incorporated in a developing apparatus for printing plates, comprising at least one doctor blade made of a flexible material which is detachably mounted in a guide bar connected with a blade holder the ends of which can be inserted from the top into an U-shaped channel-section member each of which is open towards the top and has two legs joined in spaced relationship with respect to one another by way of a web, the blade holder being provided with adjusting means mounted on its upper side at both sides, characterized in that a second doctor blade (2) is arranged parallel to the first doctor blade (1), that the two doctor blades limit a lacquer bath (3) dammed up between them and that the second doctor blade (2) is connected with an adjusting means (6) by which it can be adjusted in height, independently of the height of the first doctor blade (1).

2. A metering device as claimed in claim 1, wherein a spray tube (7) which serves to supply lacquer to the lacquer bath (3) is arranged above said lacquer bath (3) and wherein said spray tube (7) is connected by a hose connection (8) with a metering pump (24) the running time of which can be controlled via a timing element (25).

3. A metering device al claimed in claim 1 or claim 2, wherein the two doctor blades (1 and 2) have a constant distance from each other in the horizontal direction, wherein the doctor blades are both inclined with respect to the printing plate (16, 16') at an angle deviating from 90° and wherein the second doctor blade (2), as viewed in the direction of travel A of the printing plate (16'), with its underside is spaced a distance d from the printing plate surface, whereas the first doctor blade (1) is in sealing contact with the printing plate surface.

4. A metering device as claimed in one of claims 1 to 3, wherein the doctor blades (1, 2) are identically constructed and each include a head strip (12, 13) with an approximately annular cross-section, from which an inclined sheet-formed strip (27, 28) extends downwardly.

5. A metering device as claimed in one of claims 1 to 4, wherein a threaded bolt (26) each is mounted on the upper side of the guide bar (23) of the second doctor blade (2) close to the lateral ends of said guide bar (23), which threaded bolt (26) is passed through a holding fixture (14) and engages with said adjusting means (6) seated upon said holding ficture (14).

6. A metering device as claimed in claim 5, wherein the holding fixture (14) is connected with the blade holder (11) and is stationarily disposed together therewith.

7. A metering device as claimed in claim 2, wherein the spray tube (7) has a number of outlet openings (19) which are equally distributed over the length of said spray tube and wherein the center lines (29) of said outlet openings (19) include an acute angle with the perpendicular and point towards the surface of the lacquer bath (3) enclosed by the doctor blades (1, 2).

### Revendications

1. Dispositif de dosage de la laque dans un dispositif de développement pour plaques d'impression, comportant au moins une racle en un matériau élastique, qui est fixée de façon détachable dans une réglette de guidage qui est reliée à un porte-racle, dont les extrémités peuvent être introduites par le haut chacune dans un profilé en U ouvert vers le haut, ayant deux ailes maintenues à distance par une ame, et comportant des moyens de réglage présents des deux côtés sur la face supérieure du porte-racle, caractérisé en ce qu'une seconde racle (2) parallèle à la première racle (1) est présente, en ce que les deux racles délimitent un bain de laque (3) qui est retenu entre elles, et en ce que la seconde racle (2) est reliée à un dispositif d'ajustement (6) et au moyen de ce dernier est réglable en hauteur indépendamment de la hauteur de la première racle (1).

2. Dispositif de dosage selon la revendication 1, caractérisé en ce qu'au-dessus du bain de laque (3) est fixé un tube de pulvérisation (7) pour l'amenée de la laque au bain de laque (3) et en ce que le tube de pulvérisation (7) est relié par un raccord de tuyau (8) à une pumpe de dosage (24) dont la durée de fonctionnement peut être commandée par une commande temporisée (25).

3. Dispositif de dosage selon la revendication 1 ou 2, caractérisé en ce que les deux racles (1, 2) sont à une distance constante l'une de l'autre en direction horizontale, en ce que les deux racles sont inclinées d'un angle différent de 90° par rapport à la plaque d'impression (16, 16'), et en ce que la seconde racle (2), vue dans la direction A de déplacement de la plaque d'impression (16'), délimite une fente (d) entre sa face inférieure et la face supérieure de la plaque d'impression, tandis que la première racle (1) prend appui de manière étanche sur la face supérieure de la plaque d'impression.

4. Dispositif de dosage selon l'une des revendications 1 à 3, caractérisé en ce que les racles (1, 2) sont formées de manière indentiques et comportent une réglette supérieure (12, 13) de section sensiblement annulaire qui se prolonge vers le bas par une lèvre (27, 28) inclinée, en forme de feuille.

5. Dispositif de dosage selon l'une des revendications 1 à 4, caractérisé en ce qu'à proximité des extrémités latérales de la réglette de guidage (23) de la seconde racle (2), sur la face supérieure de la réglette de guidage (23) est monté à chaque fois un boulon fileté (26) qui traverse un support (14) et est en prise avec un système d'ajustage (6) qui prend appui sur le support (14).

6. Dispositif de dosage selon la revendication 5, caractérisé en ce que le support (5) est relié au porte-racle (11) et est monté fixe, avec ce dernier.

7. Dispositif de dosage selon la revendication 2, caractérisé en ce que le tube de pulvérisation (7) comporte un nombre de sorties (19), qui sont uniformément réparties sur la longueur du tube de pulvérisation et en ce que les lignes médianes (29) des sorties (19) font un angle aigu avec la verticale et sont dirigées sur la face supérieure du bain de laque (3) enserré par les racles (1, 2).

FIG.1

FIG.2